# EUROPEAN PATENT APPLICATION

(11) **EP 1 255 253 A1**
(43) Date of publication of application: **06.11.2002**
(21) Application number: 01303380.8
(22) Date of filing: 11.04.2001
(51) Int. Cl.: G11C 8/00, G11C 11/412

(54) **Dual port memory cell**

(71) Applicant: STMicroelectronics Limited, Almondsbury, Bristol BS32 4SQ (GB)
(72) Inventor: Barnes, William, Bristol BS32 9AR (GB)
(74) Representative: Driver, Virginia Rozanne

(57) **Abstract**

A dual port memory cell has a latch portion for holding data, first and second write transistors and first and second read transistors. The read transistors each have a control gate connected to the latch portion of the cell and a read enable terminal, wherein the read enable terminals are connected at a common read enable node to which the enabling signal is applied. This differs from existing cells in that the drive from the latch portion is through the gate of the read transistors rather than via the source/drain channels. Thus a larger size for the read transistors can be used without affecting cell stability.

## Description

The present invention relates to a dual port memory cell, particularly but not exclusively for dual port caches.

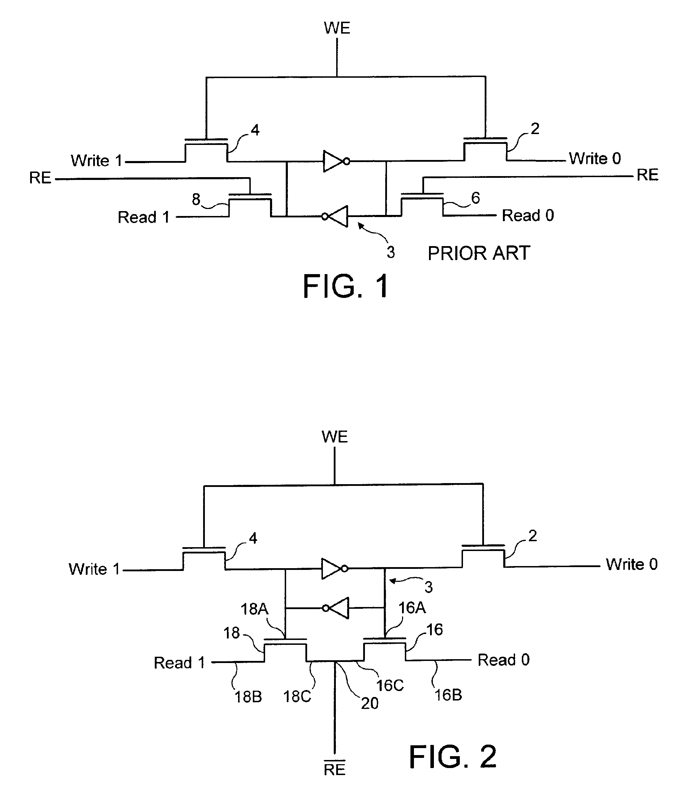

Figure 1 illustrates an existing dual port memory cell structure. The cell comprises a latch portion 3 for holding a data bit, first and second write transistors 2, 4 and first and second read transistors 6, 8. The gates of the write transistors are connected to an active high write enable signal WE. The transistor channel is connected respectively between write inputs WRITE0, WRITE1 and to the latch portion 3. The gates of the read transistors are supplied with an active high read enable signal RE. Their drains are likewise connected to the latch portion 3 and their sources connected to complementary bit line outputs READ0, READ1. It will be appreciated that herein drains and sources of the transistors are defined functionally with reference to the direction of current flow through the transistor.

The construction of the cell is symmetric as between the write and read transistors. This has the consequence that to avoid cell instability, the read and write transistors should be roughly the same size. This inherently limits the size of the read transistor which directly affects reading speed of the cell. Read current is determined by the series resistance of Tx_read and Tx_store. To avoid corruption in precharge, "cell stability" requires that R(Tx_read) = 2 x R(Tx_store) so the effective resistance R is 3 x R(Tx_store).

It is an aim of the present invention to allow larger read transistors sizes without affecting cell stability.

According to one aspect of the invention there is provided a dual port memory cell comprising: a latch portion for holding data; first and second write transistors each having a control gate connected to receive a write enable signal, a first terminal connected to said latch portion and a second terminal for connection to data to be written into said cell; first and second read transistors each having a read terminal at which data can be read from said cell; characterised in that each of the read transistors has a control gate connected to the latch portion of the cell and a read enable terminal, wherein the read enable terminals are connected at a common read enable node to which an enabling signal is applied.

Another aspect provides a memory circuit comprising an array of dual port memory cells as hereinabove defined; read enable circuitry for generating said enabling signal; and write enable circuitry for generating said write enable signal.

The dual port memory cell defined hereinabove is particularly useful for small memories such as register files. The cells described in the following have independent read and write ports and a faster reading speed than the known symmetric design or simpler read circuitry, if a trade-off against speed is acceptable. Thus, the cell described herein is optimised for high speed and simple interfacing.

For a better understanding of the present invention and to show how the same may be carried into effect, reference will now be made by way of example to the accompanying drawings, in which:
Figure 1 illustrates an existing symmetric dual port RAM cell;
Figure 2 illustrates a dual port cell in accordance with one embodiment of the invention;
Figure 3 illustrates a dual port cell in accordance with another embodiment of the present invention; and
Figure 4 is a schematic diagram of a memory circuit.

Figure 1 has already been described above. In Figures 2 to 4, like numerals denote equivalent parts to those of the circuit of Figure 1. In the first embodiment of the invention, illustrated in Figure 2, first and second write transistors 2, 4 are connected at their gates to an active high write enable signal WE. Their sources are connected to respective write inputs WRITE0, WRITE1 and their drains are connected to the latch portions 3 of the cell. In this respect, the connections of the write transistors are the same as those in the prior art circuit of Figure 1. However, the connections of the read transistors are different as described in the following.

There are first and second read transistors 16, 18, each having their gates 16a, 18a, connected respectively to the latch portion 3 of the memory cell. Their sources 16b, 18b are connected to draw current from complementary bit lines READ0, READ1 and their drains 16c, 18c are connected at a read enable terminal 20.

An active low read enable signal RE is applied to the read enable terminal 20. Thus, to enable reading of the cell, the read enable signal is low such that RE is high. This causes a voltage Vdd to be applied across the read transistors 16, 18 thus allowing the logical state at the gate 16a, 18a of the transistors to be applied to the bit line outputs READ0, READ1 respectively. It will be apparent that complementary outputs are produced at the READ0 and READ1 outputs respectively.

This configuration has the advantage that a larger size for the read transistors 16, 18 can be used without affecting cell stability, because the drive from the latch portion is through the gate of the read transistors rather than via the source/drain channel. That is, the current drawn by the gate of the read transistor is minimal.

However, the cell in Figure 2, while being advantageous with respect to the prior art cell of Figure 1, is only really suitable for self-timed design because when the cell of Figure 2 is read, all other cells which are high on the read bit line in the column of the memory array in which the cell is located cause the read bit line swing to be limited to Vdd - Vt, where Vt is the threshold voltage of the read transistor.

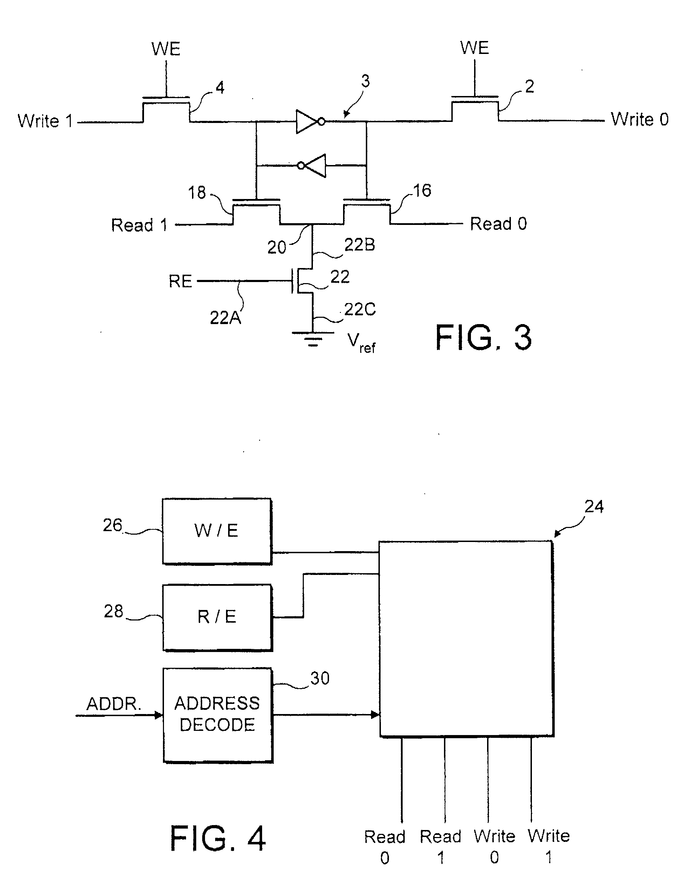

An alternative embodiment is illustrated in Figure 3, which does not suffer from this disadvantage. In Figure 3, like numerals denote like parts as in Figure 2, and it will also be noted that the connections are the same for the read and write transistors. The embodiment of Figure 3 differs from that of Figure 2 in that an extra read enable transistor 22 is provided which has its gate 22a connected to an active high read enable signal RE, its source 22b connected to the read enable terminal 20 and its drain 22c connected to a reference voltage, in this case ground. For reading, the active high read enable signal RE turns on the read enable transistor 22. This pulls the read enable node 20 down to ground, thus eliminating the limit on the read bit line swing. Thus, this embodiment is suitable for self-timed or precharge/evaluate designs as the read bit line is free to fall to ground when reading.

Figure 4 illustrates a memory circuit using the dual port memory cell design of Figure 2 or Figure 3. Reference numeral 24 denotes a memory circuit in the form of a register file which comprises a plurality of such cells arranged in rows to constitute individual registers in a known fashion. A common write enable signal feeds the write transistors of each cell, and a common read enable signal feeds the read transistors of each cell. These are supplied by write enable circuitry 26 and read enable circuitry 28 respectively. An address decoder 30 selects the cells for reading/writing in accordance with an input address. The complementary bit line outputs are labelled READ0, READ1 in Figure 4, and the write inputs are labelled WRITE0, WRITE1 in Figure 4.

## Claims

1. A dual port memory cell comprising:
a latch portion for holding data;
first and second write transistors each having a control gate connected to receive a write enable signal, a first terminal connected to said latch portion and a second terminal for connection to data to be written into said cell;
first and second read transistors each having a read terminal at which data can be read from said cell;
**characterised in that** each of the read transistors has a control gate connected to the latch portion of the cell and a read enable terminal, wherein the read enable terminals are connected at a common read enable node to which an enabling signal is applied.

2. A dual port memory cell according to claim 1, wherein the read transistors are NMOS transistors having their drains connected at the common read enable terminal and their sources acting as the read terminals.

3. A dual port memory cell according to claim 1 or 2, wherein the common read enable node is connected to receive an active low read enable signal.

4. A dual port memory cell according to claim 1 or 2, which comprises a read control transistor having a control gate connected to receive a read enable signal and a controllable path connected between the common read enable node and a reference voltage.

5. A dual port memory cell according to claim 4, wherein the read enable signal is active high and the read control transistor is an NMOS transistor.

6. A memory circuit comprising:
an array of dual port memory cells according to any preceding claim;
read enable circuitry for generating said enabling signal; and
write enable circuitry for generating said write enable signal.

7. A memory circuit according to claim 6, when used as a register file.
